Europäisches Patentamt

European Patent Office

Office européen des brevets

(11) Publication number: **0 178 044**
A2

# EUROPEAN PATENT APPLICATION

(21) Application number: 85305374.2

(22) Date of filing: 29.07.85

(51) Int. Cl.⁴: **H 04 N 5/14**

(30) Priority: 28.07.84 JP 158341/84

(43) Date of publication of application: 16.04.86
Bulletin 86/16

(84) Designated Contracting States: DE FR GB NL

(71) Applicant: VICTOR COMPANY OF JAPAN, LIMITED,
12, 3-chome, Moriya-Cho Kanagawa-ku, Yokohama-Shi
Kanagawa-Ken (JP)

(72) Inventor: Furuki, Tsuneo, 4-27-21, Chuorinkan,
Yamato-Shi Kanagawa-Ken (JP)
Inventor: Suzuki, Fujio, 2606-67, Naruse, Machida-Shi
Tokyo (JP)

(74) Representative: Robinson, John Stuart et al, Marks &
Clerk 57/60 Lincoln's Inn Fields, London WC2A 3LS (GB)

(54) Analogue-to-digital converting apparatus for video signals.

(57) An analog-to-digital converting apparatus comprises a clamping circuit (32) for clamping a reference level of an input analog video signal supplied thereto, an amplifying circuit (33) for amplifying an output signal of the clamping circuit, an analog-to-digital converting circuit (34) for generating a digital video signal by subjecting an output signal of the amplifying circuit (33) to an analog-to-digital conversion, and a control signal generating circuit (35, 36) for generating at least for the duration of a horizontal synchronizing signal of the input analog video signal a control signal responsive to a difference between the value of the output digital video signal of the analog-to-digital converting circuit (34) and the value of a preset reference signal. The control signal is supplied to one or two out of the clamping circuit (32), the amplifying circuit (33), and the analog-to-digital converting circuit (34) to variably control one or two out of a clamping voltage of the clamping circuit (32), an offset voltage of the amplifying circuit (33), and a first reference voltage of the analog-to-digital converting circuit (34) so that the value of the difference becomes a minimum.

ANALOG-TO-DIGITAL CONVERTING APPARATUS

The present invention generally relates to analog-to-digital converting apparatuses, and more particularly to an analog-to-digital converting apparatus which subjects an input analog video signal to an analog-to-digital conversion and generates a digital video signal having a predetermined quantization number of bits per picture element.

An analog-to-digital converting apparatus (hereinafter simply referred to as an A/D converting apparatus) is used when transmitting an analog video signal in the form of a digital video signal having a predetermined quantization number of bits. A first example of a conventional A/D converting apparatus generally comprises a first buffer amplifier, a coupling capacitor, a second buffer amplifier, a switching circuit, a clamping voltage source, an analog-to-digital (A/D) converter, and a reference voltage source. An input analog video signal such as a composite video signal, a luminance signal, a color difference signal, or one of three primary color signals, is passed through the first buffer amplifier and the coupling capacitor and is supplied to the second buffer amplifier. The switching circuit is turned ON during a horizontal blanking period of the input analog video signal, and during this time period, a potential at a connection point of the coupling capacitor, the switching circuit, and the second buffer amplifier is fixed to a clamping voltage which has a predetermined level and is obtained from the clamping voltage source. During time periods other than the horizontal blanking period, the switching circuit is turned OFF, and the analog video signal obtained through the coupling capacitor is supplied as it is to the second buffer amplifier. However, in this state, the terminal voltage of the coupling capacitor is charged up to a level which is the same as that of the clamping voltage, and an analog video signal having the clamping voltage as a reference D.C. voltage is supplied to the second buffer amplifier. An analog video signal obtained from the second buffer amplifier is subjected to an analog-to-digital conversion in the A/D converter which is determined of the dynamic range thereof responsive to a reference voltage obtained from the reference voltage source. As a result, a digital video signal having a predetermined quantization number of bits per picture element is generated.

As a second example of a conventional A/D converting apparatus, there is an A/D converting apparatus which is provided with a differential amplifier instead of the second buffer amplifier of the first example of the conventional A/D converting apparatus described above. In this case, the analog video signal obtained through the coupling capacitor and the clamping voltage obtained from the switching circuit are both applied to one input terminal of the differential amplifier, and an output signal of the differential amplifier is supplied to the A/D converter. An offset voltage obtained from an offset voltage source is applied to the other input terminal of the differential amplifier.

A third example of a conventional A/D converting apparatus is provided with an analog comparator and a second switching circuit in addition to the circuit elements of the second example of the conventional A/D converting apparatus. In this case, the analog video signal obtained through the coupling capacitor and the clamping voltage obtained from the switching circuit are both applied to one input terminal of the differential amplifier, and an output signal of the differential amplifier is supplied to the A/D converter.

apparatus described above. In this case, the level of the output signal of the differential amplifier is compared with the level of a predetermined reference voltage in the analog comparator, and an output signal of the analog comparator is supplied to the second switching circuit. The second switching circuit is turned ON during the horizontal blanking period, and the output signal of the analog comparator is supplied to the clamping voltage source or the offset voltage source so as to variably control an output voltage thereof.

The brightness, the light and shade and the like of an optical display on a display device are determined by the signal level of the analog video signal with respect to a reference D.C. voltage (reference level). Accordingly, it is of much importance to control the reference level. In the case where the analog video signal is the composite video signal, the reference level is the pedestal level. On the other hand, in the case where the analog video signal is the luminance signal, the color difference signal or the primary color signal, the reference level is the signal level in the horizontal blanking period. In addition, the quality of the gradation of the video signal after the A/D conversion is proportional to the quantization number of bits of the digital video signal, and in order to obtain a satisfactory gradation, it is essential that the reference level is set to an optimum level with respect to the dynamic range of the A/D converter.

Hence, in the first example of the conventional A/D converting apparatus, the output clamping voltage of the clamping voltage source is manually adjusted so that the reference level is set to the optimum level with respect to the dynamic range of the A/D converter. In the second example of the conventional A/D converting apparatus, the clamping voltage is fixed and the output offset voltage of the offset voltage source is manually adjusted so that the reference level is set to the optimum level. Further, in the third example of the conventional A/D converting apparatus, in order to set the reference level to the optimum level, the output voltage of the clamping voltage source or the offset voltage source is adjusted so that a level difference between the output signal of the differential amplifier and the predetermined reference voltage becomes a minimum.

However, in the first and second examples of the conventional A/D converting apparatus, there are problems in that it takes time to perform the adjustment and that the adjusting operation is troublesome to perform because the adjusting operation is performed manually. On the other hand, in the first through third examples of the conventional A/D converting apparatus, the adjustment is only performed in the analog circuit part of the apparatus. For this reason, there is another problem in that it is impossible to obtain a satisfactory adjusting precision and adjusting range due to an error introduced by the temperature characteristics of the circuit elements which constitute the A/D converter, an adjusting error and the like.

Accordingly, it is a general object of the present invention to provide a novel and useful A/D converting apparatus in which the problems described heretofore are eliminated.

Another and more specific object of the present invention is to provide an A/D converting apparatus comprising a clamping circuit supplied with an input analog video signal, an amplifying circuit supplied with an output signal of the clamping circuit, an A/D converting circuit for subjecting an output signal of the amplifying circuit to an A/D conversion, a digital-to-analog (D/A) converting circuit for subjecting an output signal of the A/D converting circuit to a digital-to-analog (D/A) conversion, and an analog comparing circuit for detecting a difference between the value of an output signal of the D/A converting circuit and the value of a predetermined reference signal and for controlling by an output signal of the analog comparing circuit one or two out of a clamping voltage of the clamping circuit, an offset voltage of the amplifying circuit, and a reference voltage which determines the dynamic range of the A/D converting circuit. According to the A/D converting apparatus of the present invention, the analog comparing circuit supplies to one or two out of the clamping circuit, the amplifying circuit, and the A/D converting circuit a control signal responsive to an error introduced due to the temperature characteristics of the circuit elements which constitute the A/D converting circuit, an adjusting error and the like. Hence, it is possible to compensate for the error introduced due to the temperature characteristics of the circuit elements which constitute the A/D converting circuit, the adjusting error and the like, and the reference level of the input analog video signal can constantly and automatically be adjusted to a predetermined level. As a result, it is possible to set the reference level to an optimum level with respect to the dynamic range of the A/D converting circuit.

Still another object of the present invention is to provide an A/D converting apparatus comprising a clamping circuit supplied with an input analog video signal, an amplifying circuit supplied with an output signal of the clamping circuit, an A/D converting circuit for subjecting an output signal of the amplifying circuit to an A/D conversion, and a digital comparator for detecting a difference between the value of an output digital signal of the A/D converting circuit and the value of a predetermined digital reference value and for controlling by an output signal of the digital comparator one or two out of a clamping voltage of the clamping circuit, an offset voltage of the amplifying circuit, and a reference voltage which determines the dynamic range of the A/D converting circuit. According to the A/D converting apparatus of the present invention, the digital comparator supplies to one or two out of the clamping circuit, the amplifying circuit, and the A/D converting circuit a control signal which is obtained by comparing the output digital signal of the A/D converting circuit with the digital reference value, without converting the output digital signal of the A/D converting circuit into an analog signal. Thus, in addition to the advantageous features described before, it is possible to adjust the reference level of the input analog video signal by an extremely stable circuit.

Other objects and further features of the present invention will be apparent from the following detailed description when read in conjunction with the accompanying drawings.

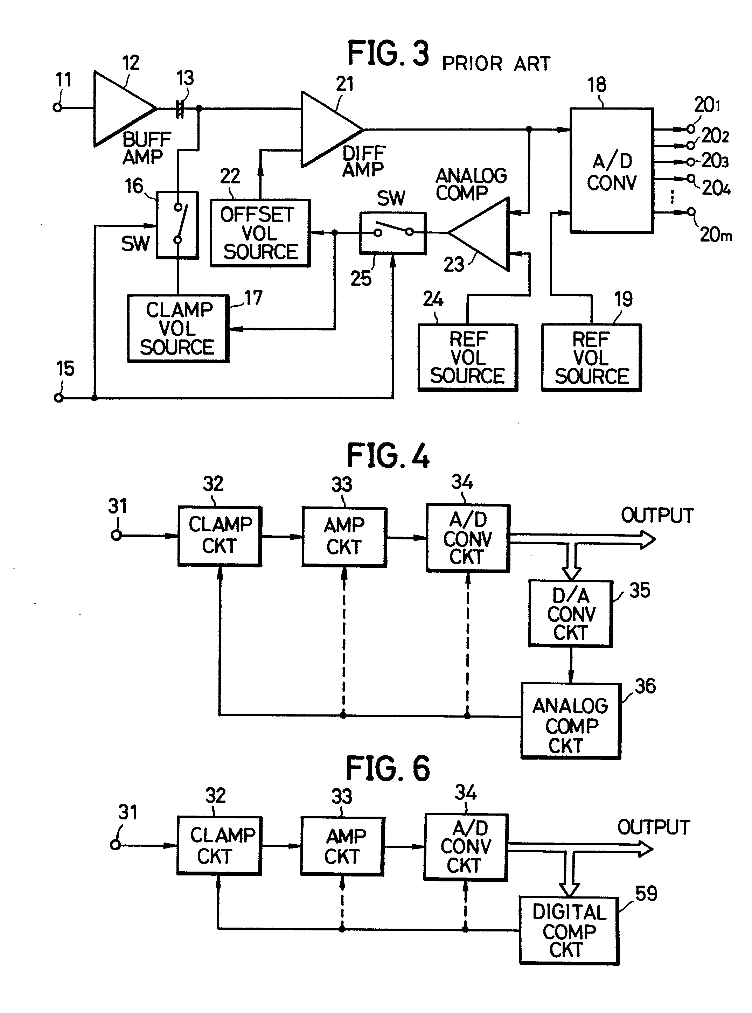

FIG.1 is a system block diagram showing a first example of the conventional A/D converting apparatus;
FIG.2 is a system block diagram showing a second
example of the conventional A/D converting apparatus;
FIG.3 is a system block diagram showing a third
example of the conventional A/D converting apparatus;
FIG.4 is a system block diagram showing a first
embodiment of the A/D converting apparatus according
to the present invention;
FIG.5 is a system block diagram showing an embodiment
of a concrete construction of the block system shown
in FIG.4;

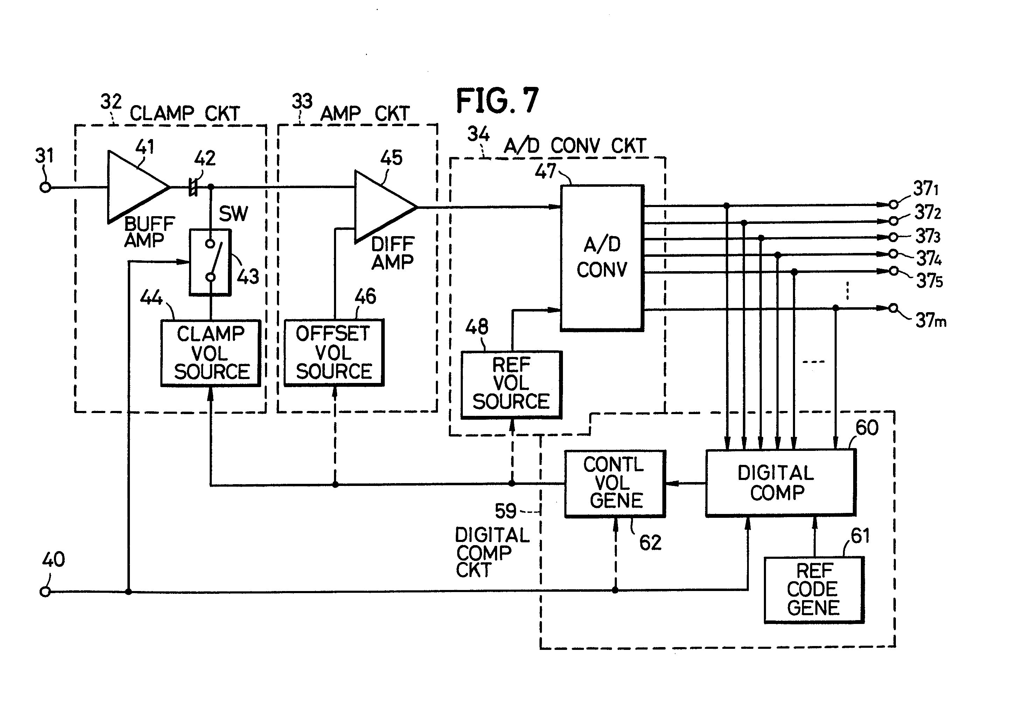

FIG.6 is a system block diagram showing a second
embodiment of the A/D converting apparatus according
to the present invention; and
FIG.7 is a system block diagram showing an embodiment
of a concrete construction of the block system shown
in FIG.6.

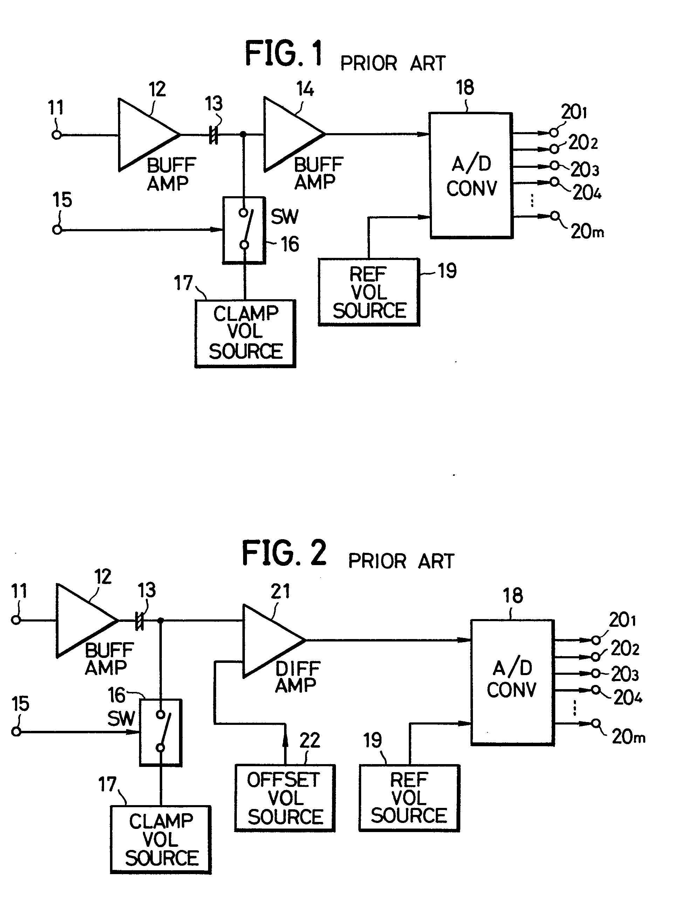

FIG.1 is a system block diagram showing a first example of
the conventional A/D converting apparatus. In FIG.1, an
input analog video signal (that is, a composite video
signal, a luminance signal, a color difference signal, or
a primary color signal) is applied to an input terminal
11. The input analog video signal is passed through a
buffer amplifier 12 and a coupling capacitor 13 and is
supplied to a buffer amplifier 14. On the other hand, a
clamping pulse which assumes a predetermined level for
every horizontal blanking period of the input analog video
signal is applied to an input terminal 15. The clamping
pulse is supplied to a switching circuit 16, and the
switching circuit 16 is turned ON during a time period in
which the clamping pulse is supplied thereto.
Accordingly, a potential at a connection point of the coupling capacitor 13, the switching circuit 16, and the buffer amplifier 14 is fixed to a preset clamping voltage which has a predetermined level and is obtained from a clamping voltage source 17, during a time period in which the switching circuit 16 is turned ON (during the horizontal blanking period). During time periods other than the horizontal blanking period, in which time periods no clamping pulse is applied to the terminal 15, the switching circuit 16 is turned OFF. Hence, the analog video signal obtained through the coupling capacitor 13 is supplied as it is to the buffer amplifier 14 during the time periods other than the horizontal blanking period, but since the terminal voltage of the coupling capacitor 13 is charged up to a level which is the same as that of the clamping voltage, the analog video signal is supplied to the buffer amplifier 14 with the clamping voltage as the reference D.C. voltage (reference level).

The analog video signal obtained through the buffer amplifier 14 is supplied to an A/D converter 18 wherein the signal is subjected to an A/D conversion. Hence, a digital video signal having a predetermined quantization number of bits per picture element is generated from the A/D converter 18 and is obtained through output terminals $20_1$ through $20_m$. A reference voltage for determining the dynamic range of the A/D converter 18 is supplied to the A/D converter 18 from a reference voltage source 19.

FIGS.2 and 3 are system block diagrams showing second and third examples of the conventional A/D converting apparatus, respectively. In FIGS.2 and 3, those parts which are the same as those corresponding parts in FIG.1 are designated by the same reference numerals and description thereof will be omitted. In the conventional apparatus shown in FIG.2, the analog video signal obtained through the coupling capacitor 13 and the clamping voltage obtained from the switching circuit 16 are applied to one input terminal of a differential amplifier 21. An offset voltage obtained from an offset voltage source 22 is applied to the other input terminal of the differential amplifier 21. An output signal of the differential amplifier 21 is supplied to the A/D converter 18.

In the conventional apparatus shown in FIG.3, the level of the output analog video signal of the differential amplifier 21 is compared with the level of a predetermined reference voltage obtained from a reference voltage source 24 in an analog comparator 23, and an output signal of the analog comparator 23 is supplied to a switching circuit 25. The switching circuit 25 is turned ON during a time period in which the clamping pulse obtained from the input terminal 15 is supplied thereto. Hence, during the time period in which the clamping pulse is applied to the input terminal 15, the switching circuit 25 selectively passes the output signal of the analog comparator 23. Accordingly, the output signal of the analog comparator 23 is supplied to the clamping voltage source 17 or the offset voltage source 22 to variably control the output voltage thereof.

As described before, the brightness, the light and shade and the like of an optical display on a display device are determined by the signal level of the analog video signal with respect to the reference level. Accordingly, it is of much importance to control the reference level. In the case where the analog video signal is the composite video signal, the reference level is the pedestal level. On the other hand, in the case where the analog video signal is the luminance signal, the color difference signal or the primary color signal, the reference level is the signal level in the horizontal blanking period.

In addition, the quality of the gradation of the video signal after the A/D conversion is proportional to the quantization number of bits of the digital video signal, and in order to obtain a satisfactory gradation, it is essential that the D.C. reference level is set to an optimum level with respect to the dynamic range of the A/D converter 18. Moreover, in a transmission system which does not transmit digital data during horizontal and vertical blanking periods in which the level of the digital video signal becomes equal to a specific value as is well known and only transmits digital data during video periods other than the horizontal and vertical blanking periods so as to reduce the transmitting quantity of the digital data and reduce the memory capacity of a digital memory which stores the digital video signal, it is essential to set the D.C. reference level with an extremely high accuracy in order to reproduce the gradation in the dark part in the case of the composite video signal, the luminance signal or the primary color signal and in order to reproduce the white balance in the low saturation part in the case of the color difference signal or the primary color signal.

Hence, in the first example of the conventional apparatus shown in FIG.1, the output clamping voltage of the clamping voltage source 17 is manually adjusted so that the reference level is set to the optimum level with respect to the dynamic range of the A/D converter 18.  In the second example of the conventional apparatus shown in FIG.2, the clamping voltage is fixed and the output offset voltage of the offset voltage source 22 is manually adjusted so that the reference level is set to the optimum level.  Further, in the third example of the conventional apparatus shown in FIG.3, in order to set the reference level to the optimum level, the output voltage of the clamping voltage source 17 or the offset voltage source 22 is adjusted so that a level difference between the output signal of the differential amplifier 21 and the predetermined reference voltage obtained from the reference voltage source 24 becomes a minimum.

However, in the first and second examples of the conventional apparatus shown in FIGS.2 and 3, there are problems in that it takes time to perform the adjustment and that the adjusting operation is troublesome to perform because the adjusting operation is performed manually.  On the other hand, in the first through third examples of the conventional apparatus shown in FIGS.1 through 3, the adjustment is only performed in the analog circuit part of the apparatus.  For this reason, there is another problem in that it is impossible to obtain a satisfactory adjusting precision and adjusting range due to an error introduced by the temperature characteristics of the circuit elements which constitute the A/D converter 18, an adjusting error and the like.

Accordingly, the A/D converting apparatus according to the present invention feeds back the output digital signal of the A/D converter in order to adjust the reference level to the optimum level, and the problems described heretofore are eliminated in the apparatus according to the present invention.

FIG.4 is a system block diagram showing a first embodiment of the A/D converting apparatus according to the present invention. In FIG.4, a reference level of an input analog video signal which is applied to an input terminal 31 and supplied to a clamping circuit 32, is clamped in the clamping circuit 32. An output signal of the clamping circuit 32 is passed through an amplifying circuit 33 and is supplied to an A/D converting circuit 34 wherein the signal is subjected to an A/D conversion. An output digital video signal of the A/D converting circuit 34 is supplied to a digital-to-analog (D/A) converting circuit 35 wherein the signal is subjected to a digital-to-analog (D/A) conversion. An output signal is obtained from the D/A converting circuit 35 at least for the duration of the horizontal synchronizing signal. An analog comparing circuit 36 compares the output signal of the D/A converting circuit 35 with a preset reference signal. An output signal of the analog comparing circuit 36, which is responsive to a difference between the compared signals, is supplied as a control signal to one or two out of the clamping circuit 32, the amplifying circuit 33, and the A/D converting circuit 34. As a result, one or two out of the clamping voltage of the clamping circuit 32, the offset voltage of the amplifying circuit 33, and the reference voltage for determining the dynamic range of the A/D converting circuit 34 is controlled responsive to the control signal. FIG.4 shows a case where the control signal is supplied to the clamping circuit 32, however, the the control signal may be supplied to one or two out of the clamping circuit 32, the amplifying circuit 33, and the A/D converting circuit 34 as indicated by a solid signal line and phantom signal lines.

The A/D converting apparatus shown in FIG.4 operates so that the one or two out of the clamping voltage, the offset voltage, and the reference voltage is variably controlled and the difference detected in the analog comparing circuit 36 becomes a minimum. In the present embodiment, the output digital video signal of the A/D converting circuit 34 is converted into an analog signal at least for the duration of the horizontal synchronizing signal, and the value of the analog signal is compared with the value of the preset reference signal. The control signal which is responsive to the difference between the values of the compared signals, is then supplied to one or two out of the clamping circuit 32, the amplifying circuit 33, and the A/D converting circuit 34. For this reason, the analog comparing circuit 36 generates a control signal which includes the error introduced due to the temperature characteristics of the circuit elements which constitute the A/D converting circuit 34, the adjusting error and the like.

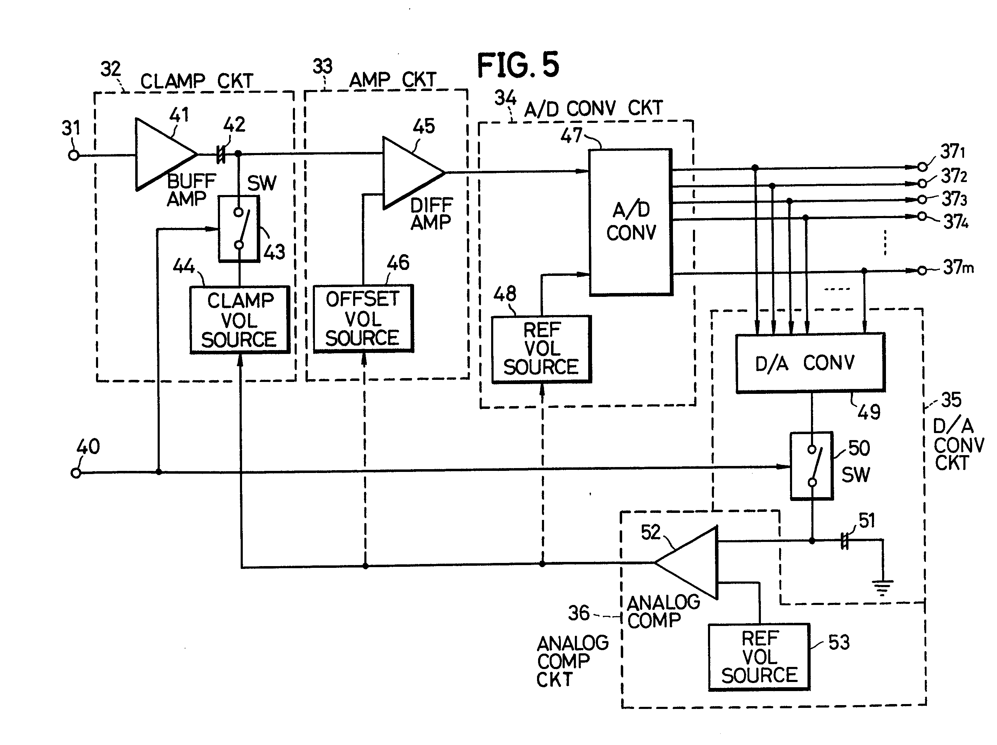

FIG.5 is a system block diagram showing an embodiment of the concrete construction of the block system shown in FIG.4. In FIG.5, those parts which are the same as those corresponding parts in FIG.4 are designated by the same reference numerals. In FIG.5, the input terminal 31 is coupled to one input terminal of a differential amplifier 45 by way of a buffer amplifier 41 and a coupling capacitor 42. A connection point between the coupling capacitor 42 and the differential amplifier 45 is coupled to a clamping voltage source 44 by way of a switching circuit 43. The buffer amplifier 41, the coupling capacitor 42, the switching circuit 43, and the clamping voltage source 44 constitute the clamping circuit 32. An output clamping voltage of the clamping voltage source 44 is variably controlled responsive to a control signal. A clamping pulse having a pulse width corresponding to the horizontal blanking period of the input analog video signal is applied to an input terminal 40. The switching circuit 43 is only turned ON for the duration of the pulse width of the clamping pulse, and the switching circuit 43 is turned OFF during other time periods. Accordingly, as described before in conjunction with FIGS.1 through 3, the reference level of the input analog video signal in the horizontal blanking period (that is, the pedestal level in the case of the composite video signal and the signal level in the horizontal blanking period in the case of the color difference signal or the primary color signal) is clamped to a predetermined D.C. voltage obtained from the clamping voltage source 44 and is supplied to the differential amplifier 45.

The differential amplifier 45 constitutes the amplifying circuit 33 together with an offset voltage source 46. The differential amplifier 45 amplifies the output analog video signal of the clamping circuit 32 and supplies the amplified signal to an A/D converter 47. The A/D converter 47 constitutes the A/D converting circuit 34 together with a reference voltage source 48. The reference voltage source 48 generates a reference voltage which determines the dynamic range of the A/D converter 47, and the output reference voltage of the reference voltage source 48 is variably controlled responsive to a control signal. For example, the A/D converter 47 is a non-feedback comparator type converter comprising $2^n - 1$ comparators each of which is supplied to one input terminal thereof with a voltage which is obtained by dividing the reference voltage from the reference voltage source 48 by $2^n$ in a voltage dividing resistor circuit and supplied to the other input terminal thereof with the analog video signal, and a decoder supplied with outputs of the comparators, where $\underline{n}$ is a natural number. However, the A/D converter 47 is not limited to the non-feedback comparator type converter.

For example, a digital video signal having a quantization number of eight bits per picture element, is generated from the A/D converter 47 and is supplied to a circuit (not shown) in a subsequent stage through output terminals $37_1$ through $37_m$. On the other hand, the output digital video signal of the A/D converter 47 is also supplied to a D/A converter 49 wherein the digital video signal is converted into an analog video signal and supplied to a switching circuit 50. The switching circuit 50 is turned ON only during the horizontal blanking period responsive to the clamping pulse from the input terminal 40, and is turned OFF during other time periods. Hence, the output analog video signal of the D/A converter 49 is selectively obtained through the switching circuit 50 only during the horizontal blanking period, and this analog video signal is supplied to a capacitor 51 so as to charge the capacitor 51. The D/A converter 49, the switching circuit 50, and the capacitor 51 constitute the D/A converting circuit 35. The terminal voltage of the capacitor 51 is applied to one input terminal of an analog comparator 52. The value of the output signal of the D/A converter 49 during the horizontal blanking period is originally known in advance, and the D/A conversion need not be carried out with respect to all gradations.

The analog comparator 52 constitutes the analog comparing circuit 36 together with a reference voltage source 53. The analog comparator 52 detects a difference between the terminal voltage of the capacitor 51 (that is, the analog value obtained by subjecting the output digital video signal of the A/D converter 47 to the D/A conversion) and a preset reference voltage obtained from the reference voltage source 53. An output signal of the analog comparator 52, which is responsive to the detected difference, is supplied as the control signal to one or two out of the clamping voltage source 44, the offset voltage source 46, and the reference voltage source 48. As a result, the reference level of the analog video signal in the horizontal blanking period is automatically adjusted to the reference voltage preset in the reference voltage source 53, and the reference level is set to the optimum level with respect to the dynamic range of the A/D converter 47.

Next, a description will be given with respect to a second embodiment of the A/D converting apparatus according to the present invention. FIG.6 is a system block diagram showing the second embodiment of the A/D converting apparatus according to the present invention. In FIG.6, those parts which are the same as those corresponding parts in FIG.4 are designated by the same reference numerals and description thereof will be omitted. In FIG.6, a digital comparing circuit 59 detects a difference between the value of the output digital video signal of the A/D converting circuit 34 at least for the duration of the horizontal synchronizing signal and a preset digital reference value, and generates a signal responsive to the detected difference.  The output signal of the digital comparing circuit 59 is supplied as a control signal to one or two out of the clamping circuit 32, the amplifying circuit 33, and the A/D converting circuit 34.  In the present embodiment, the A/D converting apparatus operates so that one or two out of the clamping voltage of the clamping circuit 32, the offset voltage of the amplifying circuit 33, and the reference voltage of the A/D converting circuit 34 is variably controlled and the detected difference in the digital comparing circuit 59 becomes a minimum.

According to the present embodiment, the value of the output digital video signal of the A/D converting circuit 34 is compared as it is with the preset digital value at least for the duration of the horizontal synchronizing signal, and the control signal responsive to the difference between the two values is supplied to one or two out of the clamping circuit 32, the amplifying circuit 33, and the A/D converting circuit 34.  As in the case of the first embodiment described before, the control signal includes the error introduced due to the temperature characteristics of the circuit elements which constitute the A/D converting circuit 34, the adjusting error and the like.

Next, a description will be given with respect to an embodiment of the concrete construction of the block system shown in FIG.6 by referring to FIG.7.  In FIG.7, those parts which are the same as those corresponding parts in FIGS.5 and 6 are designated by the same reference numerals and description thereof will be omitted. In FIG.7, the output digital video signal of the A/D converting circuit 34 is supplied to a digital comparator 60. The digital comparator 60 compares the value of the digital video signal with a preset reference code (preset digital value) obtained from a reference code generating circuit 61. For example, a commercially available integrated circuit such as a magnitude comparator LS682 manufactured by Texas Instruments of the United States can be used for the digital comparator 60. The digital comparing circuit 59 is constituted by the digital comparator 60, the reference code generating circuit 61, and a control voltage generating circuit 62. The clamping pulse from the input terminal 40 is applied to an enable terminal of the digital comparator 60, and the difference between the compared values is only detected during the horizontal blanking period. In addition, in actual practice, the reference code generating circuit 61 may be a group of switches coupled to the digital comparator 60 and the preset reference code may be supplied to the digital comparator 60 by turning ON predetermined switches out of the group of switches.

The difference between the compared values is supplied to the control voltage generating circuit 62 from the digital comparator 60, and is converted into a control voltage responsive to the difference. The control voltage generated from the control voltage generating circuit 62 is supplied as the control signal to one or two out of the clamping voltage source 44, the offset voltage source 46, and the reference voltage source 48, so as to variably control one or two out of the clamping voltage, the offset voltage, and the reference voltage. It is also possible to apply the clamping pulse from the input terminal 40 to the control voltage generating circuit 62 so that the control voltage is generated only during the horizontal blanking period.

Therefore, according to the present embodiment, the reference level of the input analog video signal during the horizontal blanking period with respect to the dynamic range of the A/D converter 47 is automatically adjusted to the optimum level as in the case of the first embodiment described before. Further, the manufacturing cost of the circuit employed in the present embodiment is considerably low, but it is still possible to obtain stable and desired precision.

In each of the embodiments described heretofore, when converting an input luminance signal into a digital signal having a quantization number of eight bits per picture element, the blanking level of the luminance signal in the horizontal blanking period is set to an 8-bit value "10" in hexadecimal. On the other hand, when converting an input color difference signal into a digital signal having a quantization number of eight bits per picture element, the blanking level of the color difference signal in the horizontal blanking period is set to an 8-bit value "80" in hexadecimal, which 8-bit value "80" is a center value. When the data in the output digital signal of the A/D converter 47 in the horizontal blanking period assumes a predetermined value ("10" in the case of the luminance signal and "80" in the case of the color difference signal), the clamping voltage is maintained constant as it is, for example. The clamping voltage is increased when the data assumes a value smaller than the predetermined value, and the clamping voltage is decreased when the data assumes a value larger than the predetermined value. As a result, it is possible to carry out the A/D conversion with a constant blanking level.

The present invention is not limited to the first and second embodiments described heretofore, and for example, a blanking pulse or a horizontal synchronizing signal may be used instead of the clamping pulse. It is possible to employ other circuit arrangements as long as the analog comparing circuit 36 or the digital comparing circuit 59 can detect a difference between the value of the signal with the value of preset reference signal at least for the duration of the horizontal synchronizing signal and generate an output signal responsive to the detected difference.

Further, the present invention is not limited to these embodiments, but various variations and modifications may be made without departing from the scope of the present invention.

Claims:

1. An analog-to-digital converting apparatus comprising clamping means (32) for clamping a reference level of an input analog video signal supplied thereto, amplifying means (33) for amplifying an output signal of said clamping means, and analog-to-digital converting means (34) for generating a digital video signal by subjecting an output signal of said amplifying means to an analog-to-digital conversion, characterized in that there is provided control signal generating means (35, 36; 59) for generating at least for the duration of a horizontal synchronizing signal of said input analog video signal a control signal responsive to a difference between the value of the output digital video signal of said analog-to-digital converting means (34) and the value of a preset reference signal; and that said control signal is supplied to one or two out of said clamping means (32), said amplifying means (33), and said analog-to-digital converting means (34) to variably control one or two out of a clamping voltage of said clamping means, an offset voltage of said amplifying means, and a first reference voltage of said analog-to-digital converting means so that the value of said difference becomes a minimum.

2. An analog-to-digital converting apparatus as claimed in claim 1, characterized in that said control signal generating means (35, 36) comprises digital-to-analog converting means (35) for generating at least for the duration of the horizontal synchronizing signal an analog signal which is obtained by subjecting the output digital signal of said analog-to-digital converting means to a digital-to-analog conversion, and analog comparing means (36) for comparing the value of an output analog signal of said digital-to-analog converting means with the value of a preset reference signal and for generating a control signal responsive to a difference between the compared values.

3. An analog-to-digital converting apparatus as claimed in claim 2, characterized in that said digital-to-analog converting means (35) comprises a digital-to-analog converter (49) for subjecting the output digital signal of said analog-to-digital converting means to a digital-to-analog conversion, a switching circuit (50) for passing an output signal of said digital-to-analog converter for at least the duration of said horizontal synchronizing signal, and a capacitor (51) which is supplied with an output signal of said switching circuit and charged thereby.

4. An analog-to-digital converting apparatus as claimed in claim 2, characterized in that said digital-to-analog converting means (35) comprises a digital-to-analog converter (49) for subjecting the output digital signal of said analog-to-digital converting means to a digital-to-analog conversion, a switching circuit (50) for passing an output signal of said digital-to-analog converter for at least the duration of said horizontal synchronizing signal, and a capacitor (51) which is supplied with an output signal of said switching circuit and charged thereby, and said analog comparing means comprises an analog comparator (52) supplied with a terminal voltage of said capacitor and a second reference voltage for generating as said control signal a voltage responsive to a difference between the voltages supplied thereto.

5. An analog-to-digital converting apparatus as claimed in claim 1, characterized in that said control signal generating means (59) comprises digital comparing means (59) for generating at least for the duration of said horizontal synchronizing signal a control signal responsive to a difference between the value of the output digital signal of said analog-to-digital converting means and a preset digital reference value.

6. An analog-to-digital converting apparatus as claimed in claim 5, characterized in that said digital comparing means (59) comprises a digital comparator (60) for generating at least for the duration of said horizontal synchronizing signal an error signal responsive to a difference between the value of the output digital signal of said analog-to-digital converting means and said preset digital reference value, and a control signal generating circuit (62) for generating a control signal responsive to the output error signal of said digital comparator.

7. An analog-to-digital converting apparatus as claimed in claim 6, characterized in that said control signal generating circuit generates said control signal only for the duration of said horizontal synchronizing signal.

0178044

## FIG. 1 PRIOR ART

## FIG. 2 PRIOR ART

0178044

## FIG. 3 PRIOR ART

11
12 BUFF AMP
13
21 DIFF AMP
16 SW
22 OFFSET VOL SOURCE
SW
25
ANALOG COMP
23
18 A/D CONV

20₁
20₂
20₃
20₄
20m

17 CLAMP VOL SOURCE
15

24 REF VOL SOURCE
19 REF VOL SOURCE

## FIG. 4

31
32 CLAMP CKT
33 AMP CKT
34 A/D CONV CKT
OUTPUT

35 D/A CONV CKT

36 ANALOG COMP CKT

## FIG. 6

31
32 CLAMP CKT
33 AMP CKT
34 A/D CONV CKT
OUTPUT

59 DIGITAL COMP CKT

# FIG. 5

FIG.7